# EUROPEAN PATENT SPECIFICATION

(11) **EP 3 215 916 B1**
(45) Date of publication and mention of the grant of the patent: **09.01.2019**
(21) Application number: 14905433.0
(22) Date of filing: 05.11.2014
(51) Int. Cl.: G06F 3/02, H03K 17/972, G06F 3/023

(54) **INPUT DEVICES**
EINGABEVORRICHTUNGEN
DISPOSITIFS DE SAISIE

(43) Date of publication of application: 13.09.2017
(73) Proprietor: Razer (Asia-Pacific) Pte. Ltd., Singapore 469029 (SG)
(72) Inventor: LIEN, Jianyao, Singapore 469029 (SG)
(74) Representative: Viering, Jentschura & Partner mbB Patent- und Rechtsanwälte
(86) International application number: PCT/SG2014/000520
(87) International publication number: WO 2016/072930

(56) References cited:
- EP-A1- 2 731 119
- US-A1- 2006 238 281
- US-A1- 2008 264 770
- US-A1- 2013 154 940
- US-A1- 2014 014 486

## Description

### Technical Field

Various embodiments generally relate to input devices.

### Background

The keystroke force of keys on a keyboard is essential to the user experience in using the keyboard. Thus, there may be a need to improve keyboards with respect to keystroke force.

Document US-A-2008/0264770 discloses a switch comprising a keycap member in an initial position relative to a key matrix, such that pressure applied to the keycap causes an electrical contact to be made on the key matrix. A first magnet is provided in or on the keycap and a second magnet is provided at a base such that like poles of the first and second magnets are facing each other in spaced apart relation. The first and second magnets are arranged to create an opposing force between them that acts to return the key member towards the initial position when the applied force is removed.

Document US-A-2013154940 discloses a magnetic keyboard with an X-shaped holder which consists of first lever and a second lever pivotally connected to each other. A keycap is movable between a first position and a second position lower than the first position along a direction substantially perpendicular to the base plate formed with a first electromagnet and a second electromagnet. A third electromagnet, positioned opposite the second electromagnetic when keycap is in first position, slides to a position opposite the first electromagnet when keycap is in second position.

### Summary of the Invention

The present invention is defined by independent claim 1 with particular embodiments being represented by the corresponding dependent claims.

According to various embodiments, an input device may be provided. The input device may include: a housing; a keycap comprising a first magnet, the keycap being movable with respect to the housing; a second magnet being movable with respect to the housing; and an output interface configured to send data corresponding to a movement of the keycap with respect to the housing; wherein a pole of the first magnet and a pole of the same polarity of the second magnet point into at least substantially opposite directions.

### Brief Description of the Drawings

In the drawings, like reference characters generally refer to the same parts throughout the different views. The drawings are not necessarily to scale, emphasis instead generally being placed upon illustrating the principles of the invention. The dimensions of the various features or elements may be arbitrarily expanded or reduced for clarity. In the following description, various embodiments of the invention are described with reference to the following drawings, in which:
FIG. 1 shows an illustration of an adjustable keystroke force keyboard according to various embodiments;
FIG. 2A shows an input device according to various embodiments;
FIG. 2B shows an input device according to various embodiments;
FIG. 3 shows a side cross section view of an adjustable keystroke force keyboard according to various embodiments;
FIG. 4 shows a magnified side cross section view of an adjustable keystroke force keyboard according to various embodiments;
FIG. 5 shows an illustration of a sliding magnet rack movement direction according to various embodiments;
FIG. 6 shows an illustration of a side cross section view of three keys according to various embodiments;
FIG. 7 shows an illustration of a side cross section view of the three keys according to various embodiments; and
FIG. 8 shows a rack and pinion configuration according to various embodiments.

### Detailed Description

The following detailed description refers to the accompanying drawings that show, by way of illustration, specific details and embodiments in which the invention may be practiced. These embodiments are described in sufficient detail to enable those skilled in the art to practice the invention. Other embodiments may be utilized and structural, and logical changes may be made without departing from the scope of the invention. The various embodiments are not necessarily mutually exclusive, as some embodiments can be combined with one or more other embodiments to form new embodiments.

In this context, the input device as described in this description may include a memory which is for example used in the processing carried out in the input device. A memory used in the embodiments may be a volatile memory, for example a DRAM (Dynamic Random Access Memory) or a non-volatile memory, for example a PROM (Programmable Read Only Memory), an EPROM (Erasable PROM), EEPROM (Electrically Erasable PROM), or a flash memory, e.g., a floating gate memory, a charge trapping memory, an MRAM (Magnetoresistive Random Access Memory) or a PCRAM (Phase Change Random Access Memory).

In an embodiment, a "circuit" may be understood as any kind of a logic implementing entity, which may be special purpose circuitry or a processor executing software stored in a memory, firmware, or any combination thereof. Thus, in an embodiment, a "circuit" may be a hard-wired logic circuit or a programmable logic circuit such as a programmable processor, e.g. a microprocessor (e.g. a Complex Instruction Set Computer (CISC) processor or a Reduced Instruction Set Computer (RISC) processor). A "circuit" may also be a processor executing software, e.g. any kind of computer program, e.g. a computer program using a virtual machine code such as e.g. Java. Any other kind of implementation of the respective functions which will be described in more detail below may also be understood as a "circuit" in accordance with an alternative embodiment.

In order that the invention may be readily understood and put into practical effect, particular embodiments will now be described by way of examples and not limitations, and with reference to the figures.

Various embodiments are provided for devices, and various embodiments are provided for methods. It will be understood that basic properties of the devices also hold for the methods and vice versa. Therefore, for sake of brevity, duplicate description of such properties may be omitted.

It will be understood that any property described herein for a specific device may also hold for any device described herein. It will be understood that any property described herein for a specific method may also hold for any method described herein. Furthermore, it will be understood that for any device or method described herein, not necessarily all the components or steps described must be enclosed in the device or method, but only some (but not all) components or steps may be enclosed.

The term "coupled" (or "connected") herein may be understood as electrically coupled or as mechanically coupled, for example attached or fixed or attached, or just in contact without any fixation, and it will be understood that both direct coupling or indirect coupling (in other words: coupling without direct contact) may be provided.

The keystroke force of keys on an input device (for example a keyboard) is essential to the user experience in using the keyboard. According to various embodiments, an input device (for example a keyboard, a joystick or a mouse) with adjustable keystroke force (in other words: with adjustable keystroke force capability) may be provided. Users may adjust keystroke force to suit their use preference in games or for work (e.g. softer feel for gaming and harder feel for a solid typing experience for work).

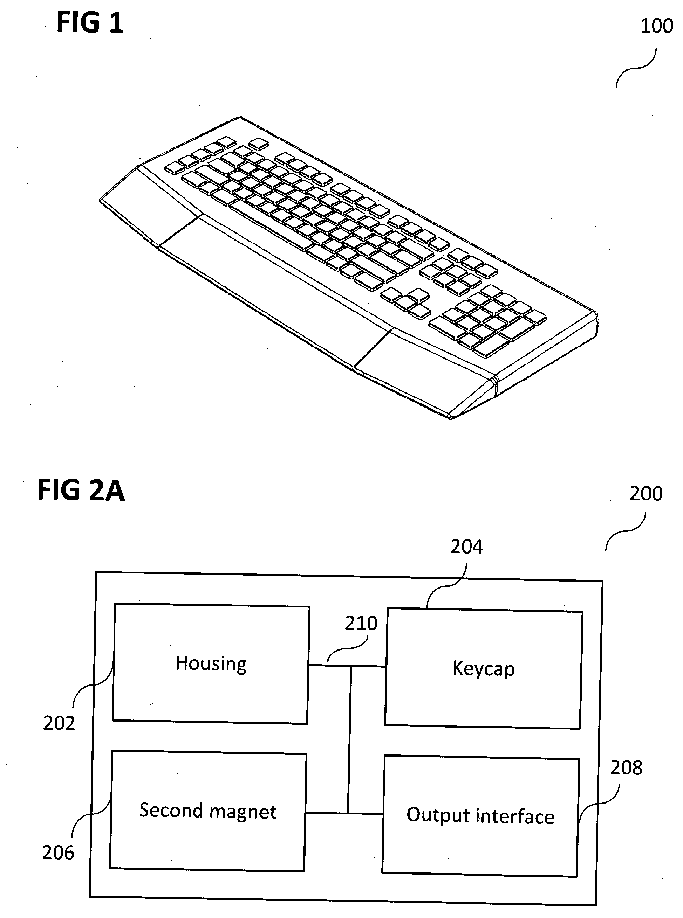

FIG. 1 shows an illustration 100 of an adjustable keystroke force keyboard according to various embodiments.

FIG. 2A shows an input device 200 according to various embodiments. The input device 200 may include a housing 202. The input device 200 may further include a keycap 204 including a first magnet. The keycap 204 may be movable with respect to the housing 202. The input device 200 may further include a second magnet 206. The second magnet 206 may be movable with respect to the housing 202. The input device 200 may further include an output interface 208 configured to send data (for example to a host computer) corresponding to a movement (for example a depression, for example a pressing, for example a hitting) of the keycap 204 with respect to the housing 202. A pole of the first magnet and a pole of the same polarity of the second magnet may point into at least substantially opposite directions. The housing 202, the keycap 204, the second magnet 206, and the output interface 208 may be coupled, for example mechanically coupled and/ or electrically coupled, like indicated by lines 210.

In other words, according to various embodiments, an input device may include at least one key (the top of which may be referred to as keycap), which may include a first magnet which may be moveable together with the key (or keycap), and the input device may include a second magnet, which may be moveable independent from the keycap, and the first magnet and the second magnet may be arranged in such a way, that in a first position of the second magnet, the second magnet repels the first magnet, and that in a second position of the second magnet, the second magnet does not interact with the first magnet.

According to various embodiments, a north pole of the first magnet and a north pole of the second magnet 206 may point into at least substantially opposite directions.

According to various embodiments, a south pole of the first magnet and a south pole of the second magnet 206 may point into at least substantially opposite directions.

According to various embodiments, the keycap 204 may be movable with respect to the housing 202 at least substantially along a first axis.

According to various embodiments, the second magnet 206 may be movable with respect to the housing 202 at least substantially along a second axis.

According to various embodiments, the first axis may be at least substantially perpendicular to the second axis.

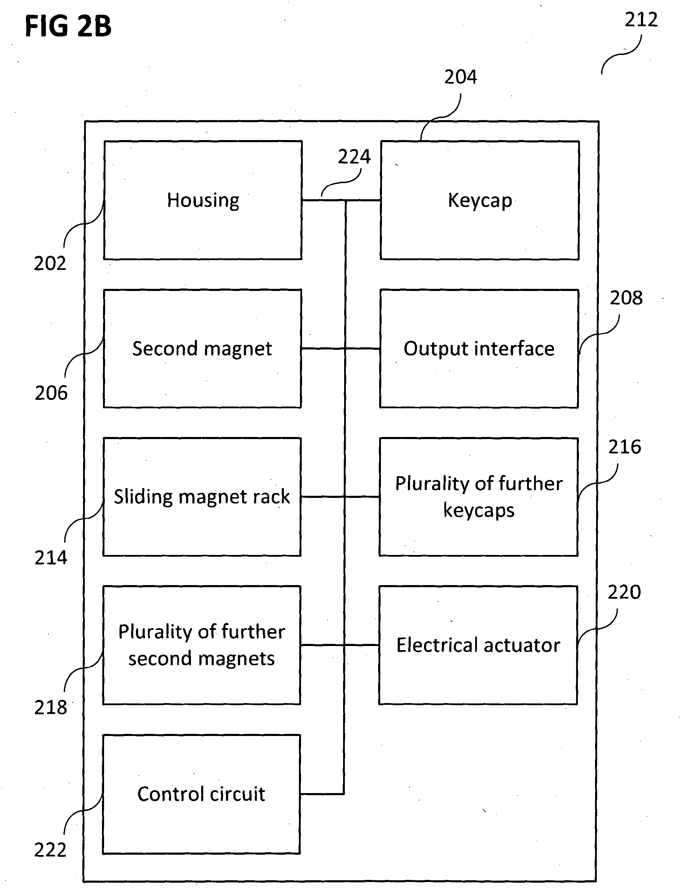

FIG. 2B shows an input device 212 according to various embodiments. The input device 212 may, similar to the input device 200 of FIG. 2A, include a housing 202. The input device 212 may, similar to the input device 200 of FIG. 2A, further include a keycap 204 including a first magnet. The keycap 204 may be movable with respect to the housing 202. The input device 212 may, similar to the input device 200 of FIG. 2A, further include a second magnet 206. The second magnet 206 may be movable with respect to the housing 202. The input device 212 may, similar to the input device 200 of FIG. 2A, further include an output interface 208 configured to send data (for example to a host computer) corresponding to a movement (for example a depression, for example a pressing, for example a hitting) of the keycap 204 with respect to the housing 202. A pole of the first magnet and a pole of the same polarity of the second magnet may point into at least substantially opposite directions. The input device 212 may further include a sliding magnet rack 214, like will be described in more detail below. The input device 212 may further include a plurality of further keycaps 216 (or at least one further keycap), like will be described in more detail below. The input device 212 may further include a plurality of further second magnets 218 (or at least one further second magnet), like will be described in more detail below. The input device 212 may further include an electrical actuator 220, like will be described in more detail below. The input device 212 may further include a control circuit 222, like will be described in more detail below. The housing 202, the keycap 204, the second magnet 206, the output interface 208, the sliding magnet rack 214, the plurality of further keycaps 216, the plurality of further second magnets 218, the electrical actuator 220, and the control circuit 222 may be coupled, for example mechanically coupled and/ or electrically coupled, like indicated by lines 224.

According to various embodiments, the sliding magnet rack 214 may include the second magnet 206.

According to various embodiments, each keycap of the plurality of further keycaps 216 may include a respective first magnet, and each keycap of the plurality of further keycaps 216 may be movable with respect to the housing 202. The plurality of further second magnets 218 may be movable with respect to the housing 202. Each first magnet of the plurality of further keycaps 216 may correspond to a second magnet of the plurality of further second magnets 218. For each keycaps of the plurality of further keycaps 216, a pole of the respective first magnet and a pole of the same polarity of the corresponding second magnet may point into at least substantially opposite directions.

According to various embodiments, polarities of adjacent second magnets may be at least substantially parallel.

According to various embodiments, polarities of adjacent second magnets may be at least substantially antiparallel.

According to various embodiments, the sliding magnet rack 214 may include the second magnet 206 and the plurality of further second magnets 218.

According to various embodiments, the input device 212 may further include a plurality of sliding magnet racks (not shown in FIG. 2B), and each sliding magnet rack may include either the second magnet 208 or one (or more) of the plurality of second magnets 218.

According to various embodiments, the sliding magnet rack 214 (or the plurality of sliding magnet racks) may be movable and manually controlled.

According to various embodiments, the electrical actuator 220 may be configured to move the sliding magnet rack 214 (or the plurality of sliding magnet racks).

According to various embodiments, the electrical actuator 220 may include or may be a motor, a servo motor, a piezo actuator, an electromagnetic actuator, an electro-hydraulic actuator, and/ or an electro-pneumatic actuator.

According to various embodiments, the control circuit 222 may be configured to control the electrical actuator 220.

According to various embodiments, the control circuit 222 may be configured to control the electrical actuator 220 based on an input from the host computer.

According to various embodiments, the control circuit 222 may be configured to control the electrical actuator 220 based on an input to the input device.

According to various embodiments, the input device 212 may be a keyboard, a joystick, a mouse or a combined input device (combining a keyboard and/ or a joystick and/ or a mouse).

According to various embodiments, a method for operating (or controlling) an input device may be provided.

According to various embodiments, a method for manufacturing an input device may be provided.

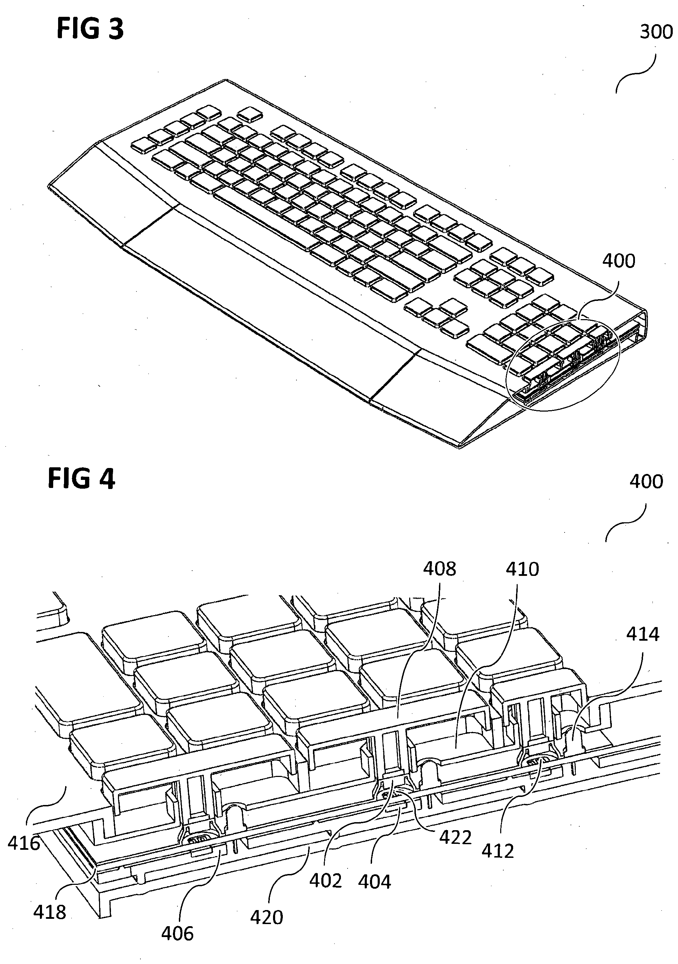

FIG. 3 shows a side cross section view 300 of an adjustable keystroke force keyboard according to various embodiments. A portion 400 of the adjustable keystroke force keyboard will be described in the following.

FIG. 4 shows a magnified side cross section view 400 of an adjustable keystroke force keyboard according to various embodiments. It will be understood that although only one of each components of the adjustable keystroke force keyboard is labelled and described with reference to FIG. 4, a plurality of keys may be provided, and each key may include all or some of the components described and labelled in FIG. 4; furthermore, it will be understood that due to space restrictions for reference signs in FIG. 4, components of different keys may be labelled; however, a person skilled in the art will understand that usually components of the same key interact accordingly. A plurality of keycaps may be provided. Each keycap (an exemplary one marked as 408 in FIG. 4) may be pushed upwards by its embedded magnet (which may be referred to as a first magnet or a top magnet, for example top magnet 402) that is being repelled by another magnet (which may be referred to as a second magnet or bottom magnet, for example bottom magnet 404) embedded in a sliding magnet rack 406 (with same poles of the top magnet 402 and the bottom magnet 404 facing each other) beneath a PCB (printed circuit board) 418 and a rubber dome sheet 412 (or rubber dome contact 412). The sliding magnet rack 406 may be guided by a sliding magnet rack guide 420. A purpose of the rubber dome sheet 412 may be to provide user with a tactile feedback upon depression of the keycap 408. When the keycap 408 is depressed, a PCB contact 422 may be closed and a signal corresponding to the depressed keycap 408 may be sent to a computing device. The upward force provided by the rubber dome sheet may be a minimum of less than 20g while still maintaining a good tactile feedback. This rubber dome layer may be removed and replaced by haptic feedback circuitry to mimic the tactile feel when depressing the keycaps. A top cover 416, a mid housing 410 may be provided. A backlight LED (light emitting diode) 414 may illuminate portions of the keyboard.

The required amount of force (keystroke force) to depress the keycap is maximum when the top and bottom magnets are aligned, like will be described with reference to the following figures.

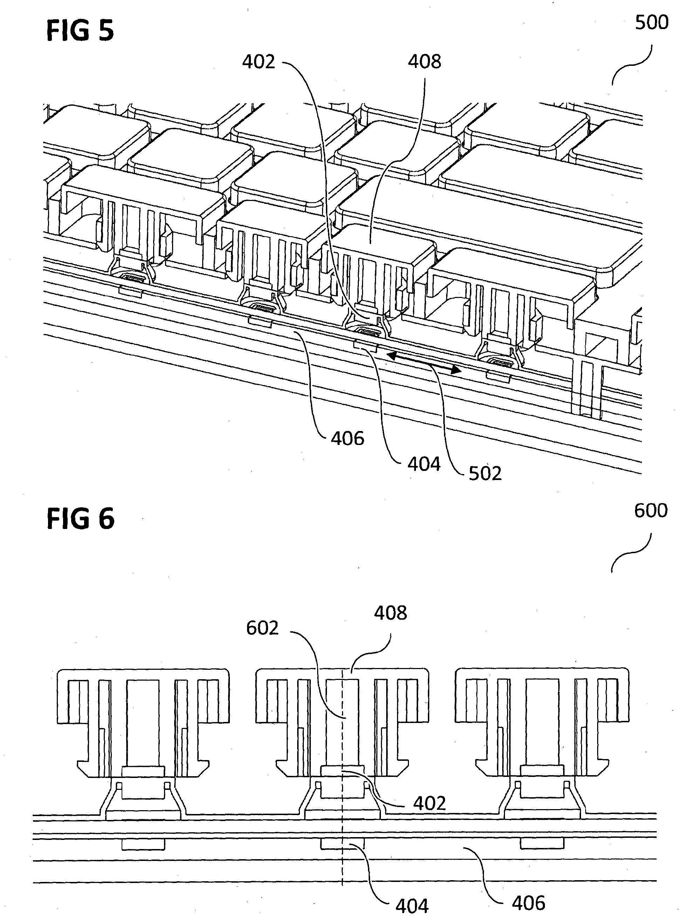

FIG. 5 shows an illustration 500 of a sliding magnet rack movement direction according to various embodiments. Various elements shown in FIG. 5 may be similar or identical to elements shown in FIG. 4, so that duplicate description may be omitted and the same reference signs may be used. The sliding magnet rack 406 (and with it the bottom magnet 404 corresponding to the keycap 408 with the top magnet 402) may be moved, for example in a lateral direction, like indicated by arrow 502. The Keystroke force is lowered by moving the magnets (i.e. the top magnet 402 and the bottom magnet 404) out of alignment. This is achieved by the sliding movement of the sliding magnet rack 406. The range of sliding movement may be variable (inversely proportional to keystroke force) and may be limited depending on the size and magnetic strength of the magnets used in order to achieve proper operation.

FIG. 6 shows an illustration 600 of a side cross section view 600 of three keys according to various embodiments. Various elements shown in FIG. 6 may be similar or identical to elements shown in FIG. 4, so that duplicate description may be omitted and the same reference signs may be used. A dashed line 602 indicates along which way the keycap 408 may move. When the top magnet 402 and the bottom magnet 404 are aligned (like shown in FIG. 6), a maximum keystroke force may be provided.

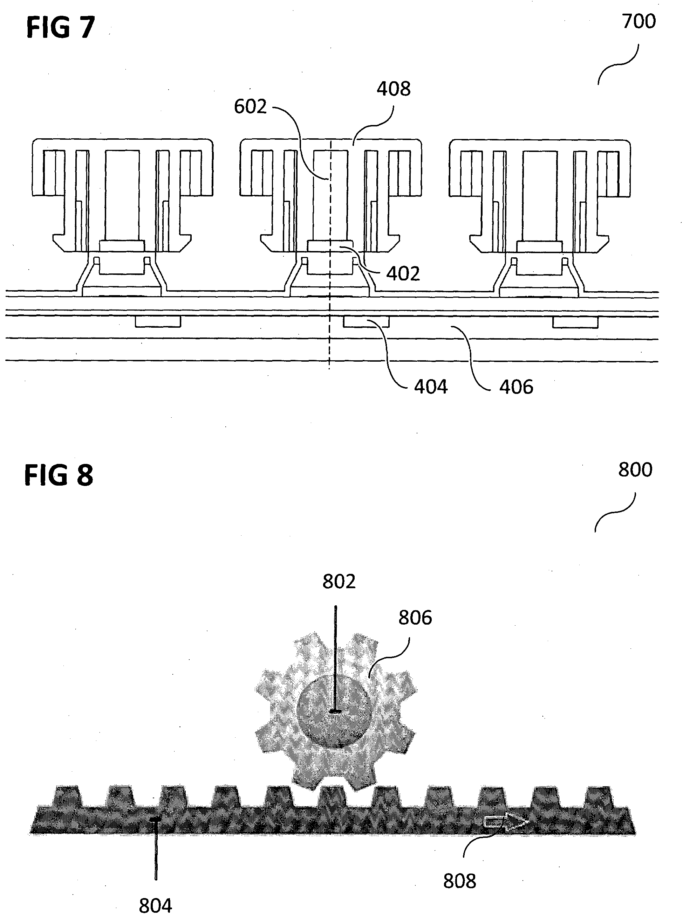

FIG. 7 shows an illustration 700 of a side cross section view 700 of the three keys according to various embodiments. Various elements shown in FIG. 7 may be similar or identical to elements shown in FIG. 4 and FIG. 6, so that duplicate description may be omitted and the same reference signs may be used. When the top magnet 402 and the bottom magnet 404 are not aligned (like shown in FIG. 7), the keystroke force may be lower than in the case when the top magnet 402 and the bottom magnet 404 are aligned (like shown in FIG. 6).

According to various embodiments, the actuation of the sliding magnet rack 406 may be done by the use of an electrical servo in a rack and pinion configuration (for example like described with reference to FIG. 8 below) for a linear motion. This may allow software control of keystroke force and different keystroke forces may be set automatically depending on the application launched by the user.

According to various embodiments, the actuation of the sliding magnet rack 406 may be done by the use of a sliding tab that is manually controlled by the user.

FIG. 8 shows a rack and pinion configuration 800 according to various embodiments. A pinion 802 (which for example may be actuated by a motor, for example by an electrical servo, or which may be actuated by a user turning the pinion 802) may engage with a rack 804. As such, the rack 804 may be actuated by the pinion 802. When the pinion 802 rotates counterclockwise (like illustrated by arrow 806), the rack 804 may move to the right (like illustrated by arrow 808). Vice versa, when the pinion 802 rotates clockwise, the rack 804 may move to the left. According to various embodiments, the magnetic rack provided in the keyboard may be actuated by a rack and pinion configuration as described herein.

The following examples pertain to further embodiments.

Example 1 is an input device comprising: a housing; a keycap comprising a first magnet, the keycap being movable with respect to the housing; a second magnet being movable with respect to the housing; and an output interface configured to send data corresponding to a movement of the keycap with respect to the housing; wherein a pole of the first magnet and a pole of the same polarity of the second magnet point into at least substantially opposite directions.

In example 2, the subject-matter of example 1 can optionally include that a north pole of the first magnet and a north pole of the second magnet point into at least substantially opposite directions.

In example 3, the subject-matter of any one of examples 1 to 2 can optionally include that a south pole of the first magnet and a south pole of the second magnet point into at least substantially opposite directions.

In example 4, the subject-matter of any one of examples 1 to 3 can optionally include that the keycap is movable with respect to the housing at least substantially along a first axis.

In example 5, the subject-matter of example 4 can optionally include that the second magnet is movable with respect to the housing at least substantially along a second axis.

In example 6, the subject-matter of example 5 can optionally include that the first axis is at least substantially perpendicular to the second axis.

In example 7, the subject-matter of any one of examples 1 to 6 can optionally include a sliding magnet rack comprising the second magnet.

In example 8, the subject-matter of any one of examples 1 to 7 can optionally include: a plurality of further keycaps, each keycap comprising a respective first magnet, each keycap being movable with respect to the housing; and a plurality of further second magnets being movable with respect to the housing; wherein each first magnet of the plurality of further keycaps corresponds to a second magnet of the plurality of further second magnets; and wherein for each keycaps of the plurality of further keycaps, a pole of the respective first magnet and a pole of the same polarity of the corresponding second magnet point into at least substantially opposite directions.

In example 9, the subject-matter of example 8 can optionally include that polarities of adjacent second magnets are at least substantially parallel.

In example 10, the subject-matter of any one of examples 8 to 9 can optionally include that polarities of adjacent second magnets are at least substantially antiparallel.

In example 11, the subject-matter of any one of examples 8 to 10 can optionally include: a sliding magnet rack comprising the second magnet and the plurality of further second magnets.

In example 12, the subject-matter of any one of examples 8 to 11 can optionally include: a plurality of sliding magnet racks, each sliding magnet rack comprising either the second magnet or one of the plurality of second magnets.

In example 13, the subject-matter of example 11 can optionally include that the sliding magnet rack is movable and manually controlled.

In example 14, the subject-matter of any one of examples 11 or 13 can optionally include an electrical actuator configured to move the sliding magnet rack.

In example 15, the subject-matter of example 14 can optionally include that the electrical actuator comprises at least actuator selected from a group of actuators consisting of a motor, a servo motor, a piezo actuator, an electromagnetic actuator, an electro-hydraulic actuator, and an electro-pneumatic actuator.

In example 16, the subject-matter of any one of examples 14 to 15 can optionally include a control circuit configured to control the electrical actuator.

In example 17, the subject-matter of any one of examples 14 to 16 can optionally include that the control circuit is configured to control the electrical actuator based on an input from a host computer.

In example 18, the subject-matter of any one of examples 14 to 17 can optionally include that the control circuit is configured to control the electrical actuator based on an input to the input device.

In example 19, the subject-matter of any one of examples 1 to 18 can optionally include that the input device is at least one input device selected from a list of input devices consisting of a keyboard, a joystick and a mouse.

While the invention has been particularly shown and described with reference to specific embodiments, it should be understood by those skilled in the art that various changes in form and detail may be made therein without departing from the scope of the invention as defined by the appended claims. The scope of the invention is thus indicated by the appended claims and all changes which come within the meaning and range of equivalency of the claims are therefore intended to be embraced.

## Claims

1. An input device (212) comprising:
a housing (202);
a keycap (204, 216, 408) comprising a first magnet, the keycap being movable with respect to the housing;
a second magnet (206) being movable with respect to the housing, wherein the second magnet is movable independent from the keycap; and
an output interface (208) configured to send data corresponding to a movement of the keycap with respect to the housing;
wherein a pole of the first magnet and a pole of the same polarity of the second magnet point into at least substantially opposite directions.

2. The input device of claim 1,
wherein a north pole of the first magnet and a north pole of the second magnet point into at least substantially opposite directions.

3. The input device of claims 1 or 2,
wherein a south pole of the first magnet and a south pole of the second magnet point into at least substantially opposite directions.

4. The input device of any one of claims 1 to 3,
wherein the keycap is movable with respect to the housing at least substantially along a first axis.

5. The input device of claim 4,
wherein the second magnet is movable with respect to the housing at least substantially along a second axis;
wherein preferably the first axis is at least substantially perpendicular to the second axis.

6. The input device of any one of claims 1 to 5, further comprising:
a sliding magnet rack comprising the second magnet.

7. The input device of any one of claims 1 to 6, further comprising:
a plurality of further keycaps, each keycap comprising a respective first magnet, each keycap being movable with respect to the housing;
a plurality of further second magnets being movable with respect to the housing;
wherein each first magnet of the plurality of further keycaps corresponds to a second magnet of the plurality of further second magnets;
wherein for each keycaps of the plurality of further keycaps, a pole of the respective first magnet and a pole of the same polarity of the corresponding second magnet point into at least substantially opposite directions;
wherein preferably polarities of adjacent second magnets are at least substantially parallel or preferably at least substantially antiparallel.

8. The input device of claim 7, further comprising:
a sliding magnet rack comprising the second magnet and the plurality of further second magnets.

9. The input device of claims 7 or 8, further comprising:
a plurality of sliding magnet racks, each sliding magnet rack comprising either the second magnet or one of the plurality of second magnets.

10. The input device of claim 8,
wherein the sliding magnet rack is movable and manually controlled;
wherein the input device preferably further comprises an electrical actuator configured to move the sliding magnet rack.

11. The input device of claim 10,
wherein the electrical actuator comprises at least actuator selected from a group of actuators consisting of a motor, a servo motor, a piezo actuator, an electromagnetic actuator, an electro-hydraulic actuator, and an electro-pneumatic actuator.

12. The input device of claims 10 or 11, further comprising:
a control circuit configured to control the electrical actuator.

13. The input device of any one of claims 10 to 12,
wherein the control circuit is configured to control the electrical actuator based on an input from a host computer.

14. The input device of any one of claims 10 to 13,
wherein the control circuit is configured to control the electrical actuator based on an input to the input device.

15. The input device of any one of claims 1 to 14,
wherein the input device is at least one input device selected from a list of input devices consisting of a keyboard, a joystick and a mouse.

## Patentansprüche

1. Eine Eingabevorrichtung (212) umfassend:
ein Gehäuse (202);
eine Tastenkappe (204, 216, 408) umfassend einen ersten Magneten, wobei die Tastenkappe in Bezug auf das Gehäuse bewegbar ist;
einen zweiten Magneten (206) der in Bezug auf das Gehäuse bewegbar ist, wobei der zweite Magnet unabhängig von der Tastenkappe bewegbar ist; und
eine Ausgabeschnittstelle (208) konfiguriert um Daten, die zu einer Bewegung der Tastenkappe in Bezug auf das Gehäuse korrespondieren, zu senden;
wobei ein Pol des ersten Magneten und ein Pol gleicher Polarität des zweiten Magneten mindestens im Wesentlichen in entgegengesetzte Richtungen hinweisen.

2. Die Eingabevorrichtung nach Anspruch 1,
wobei ein Nordpol des ersten Magneten und ein Nordpol des zweiten Magneten mindestens im Wesentlichen in unterschiedlichen Richtungen hinweisen.

3. Die Eingabevorrichtung nach Anspruch 1 oder 2,
wobei ein Südpol des ersten Magneten und ein Südpol des zweiten Magneten mindestens im Wesentlichen in unterschiedlichen Richtungen hinweisen.

4. Die Eingabevorrichtung nach einem der Ansprüche 1 bis 3,
wobei die Tastenkappe mindestens in Wesentlichen entlang einer ersten Achse in Bezug auf das Gehäuse bewegbar ist.

5. Die Eingabevorrichtung nach Anspruch 4,
wobei der zweite Magnet mindestens im Wesentlichen entlang einer zweiten Achse in Bezug auf das Gehäuse bewegbar ist;
wobei vorzugsweise die erste Achse mindestens im Wesentlichen rechtwinklig zur zweiten Achse ist.

6. Die Eingabevorrichtung nach einem der Ansprüche 1 bis 5, ferner umfassend:
eine den zweiten Magneten umfassende Gleitmagnethalterung.

7. Die Eingabevorrichtung nach einem der Ansprüche 1 bis 6, ferner umfassend:
eine Mehrzahl weiterer Tastenkappen, wobei jede Tastenkappe einen jeweiligen ersten Magneten umfasst, wobei jede Tastenkappe in Bezug auf das Gehäuse bewegbar ist;
eine Mehrzahl von weiteren zweiten Magneten, die in Bezug auf das Gehäuse bewegbar sind;
wobei jeder erste Magnet der Mehrzahl von weiteren Magneten einem zweiten Magneten der Mehrzahl von weiteren zweiten Magneten entspricht;
wobei für jede Tastenkappe der Mehrzahl weiterer Tastenkappen ein Pol des jeweiligen ersten Magneten und ein Pol gleicher Polarität des jeweiligen zweiten Magneten mindestens im Wesentlichen in entgegengesetzte Richtungen hinweisen;
wobei vorzugsweise Polaritäten von benachbarten zweiten Magneten mindestens im Wesentlichen parallel oder vorzugsweise mindestens im Wesentlichen antiparallel sind.

8. Die Eingabevorrichtung nach Anspruch 7, ferner umfassend:
eine den zweiten Magneten und die Mehrzahl von weiteren zweiten Magneten umfassende Gleitmagnethalterung.

9. Die Eingabevorrichtung nach Ansprüchen 7 oder 8, ferner umfassend:
eine Mehrzahl von Gleitmagnethalterungen, wobei jede Magnethalterung jeweils entweder den zweiten Magneten oder einen der Mehrzahl von zweiten Magneten umfasst.

10. Die Eingabevorrichtung nach Anspruch 8,
wobei die Gleitmagnethalterung bewegbar und manuell kontrolliert ist;
wobei die Eingabevorrichtung vorzugsweise ferner einen elektrischen Aktuator umfasst der konfiguriert ist um die Gleitmagnethalterung zu bewegen.

11. Die Eingabevorrichtung nach Anspruch 10,
wobei der elektrische Aktuator mindestens Aktuator ausgewählt aus der Gruppe von Aktuatoren bestehend aus einem Motor, einem Servomotor, einem piezo Aktuator, einem elektromagnetischen Aktuator, einem elektro-hydraulischen Aktuator, und einem elektropneumatischen Aktuator.

12. Die Eingabevorrichtung nach Ansprüchen 10 oder 11, ferner umfassend:
eine Steuerschaltung konfiguriert um den elektrischen Aktuator zu steuern.

13. Die Eingabevorrichtung nach einem der Ansprüche 10 bis 12,
wobei die Steuerschaltung konfiguriert ist um den elektrischen Aktuator basierend auf einer Eingabe von einem Host-Rechner zu steuern.

14. Die Eingabevorrichtung nach einem der Ansprüche 10 bis 13,
wobei die Steuerschaltung konfiguriert ist um den elektrischen Aktuator basierend auf einer Eingabe zu der Eingabevorrichtung zu steuern.

15. Die Eingabevorrichtung nach einem der Ansprüche 1 bis 14,
wobei die Eingabevorrichtung mindestens eine Eingabevorrichtung ausgewählt aus der Liste von Eigabenvorrichtungen bestehend aus einer Tastatur, einem Joystick und einer Computermaus.

## Revendications

1. Dispositif d'entrée (212) comprenant :
un logement (202) ;
un capuchon de touche (204, 216, 408) comprenant un premier aimant, le capuchon de touche pouvant être déplacé par rapport au logement ;
un deuxième aimant (206) pouvant être déplacé par rapport au logement, dans lequel le deuxième aimant peut être déplacé indépendamment du capuchon de touche ; et
une interface de sortie (208) configurée pour envoyer des données correspondant à un déplacement du capuchon de touche par rapport au logement ;
dans lequel un pôle du premier aimant et un pôle de la même polarité du deuxième aimant pointent dans des directions au moins sensiblement opposées.

2. Dispositif d'entrée selon la revendication 1,
dans lequel un pôle nord du premier aimant et un pôle nord du deuxième aimant pointent dans des directions au moins sensiblement opposées.

3. Dispositif d'entrée selon la revendication 1 ou 2,
dans lequel un pôle sud du premier aimant et un pôle sud du deuxième aimant pointent dans des directions au moins sensiblement opposées.

4. Dispositif d'entrée selon l'une quelconque des revendications 1 à 3,
dans lequel le capuchon de touche peut être déplacé par rapport au logement au moins sensiblement le long d'un premier axe.

5. Dispositif d'entrée selon la revendication 4,
dans lequel le deuxième aimant peut être déplacé par rapport au logement au moins sensiblement le long d'un deuxième axe ;
dans lequel, de préférence, le premier axe est au moins sensiblement perpendiculaire au deuxième axe.

6. Dispositif d'entrée selon l'une quelconque des revendications 1 à 5, comprenant en outre :
une crémaillère magnétique coulissante comprenant le deuxième aimant.

7. Dispositif d'entrée selon l'une quelconque des revendications 1 à 6, comprenant en outre :
une pluralité de capuchons de touche supplémentaires, chaque capuchon de touche comprenant un premier aimant respectif, chaque capuchon de touche pouvant être déplacé par rapport au logement ;
une pluralité de deuxièmes aimants supplémentaires pouvant être déplacés par rapport au logement ;
dans lequel chaque premier aimant de la pluralité de capuchons de touche supplémentaires correspond à un deuxième aimant de la pluralité de deuxièmes aimants supplémentaires ;
dans lequel, pour chaque capuchon de touche de la pluralité de capuchons de touche supplémentaires, un pôle du premier aimant respectif et un pôle de la même polarité du deuxième aimant correspondant pointent dans des directions au moins sensiblement opposées ;
dans lequel, de préférence, les polarités des deuxièmes aimants adjacents sont au moins sensiblement parallèles ou de préférence au moins sensiblement antiparallèles.

8. Dispositif d'entrée selon la revendication 7, comprenant en outre :
une crémaillère magnétique coulissante comprenant le deuxième aimant et la pluralité des deuxièmes aimants supplémentaires.

9. Dispositif d'entrée selon la revendication 7 ou 8, comprenant en outre :
une pluralité de crémaillères magnétiques coulissantes, chaque crémaillère magnétique coulissante comprenant soit le deuxième aimant, soit l'un de la pluralité de deuxièmes aimants.

10. Dispositif d'entrée selon la revendication 8,
dans lequel la crémaillère magnétique coulissante peut être déplacée et commandée manuellement ;
dans lequel le dispositif d'entrée comprend en outre de préférence un actionneur électrique configuré pour déplacer la crémaillère magnétique coulissante.

11. Dispositif d'entrée selon la revendication 10,
dans lequel l'actionneur électrique comprend au moins un actionneur sélectionné dans un groupe d'actionneurs consistant en un moteur, un servomoteur, un actionneur piézoélectrique, un actionneur électromagnétique, un actionneur électro-hydraulique, et un actionneur électro-pneumatique.

12. Dispositif d'entrée selon la revendication 10 ou 11, comprenant en outre :
un circuit de commande configuré pour commander l'actionneur électrique.

13. Dispositif d'entrée selon l'une quelconque des revendications 10 à 12,
dans lequel le circuit de commande est configuré pour commander l'actionneur électrique sur la base d'une entrée provenant d'un ordinateur hôte.

14. Dispositif d'entrée selon l'une quelconque des revendications 10 à 13,
dans lequel le circuit de commande est configuré pour commander l'actionneur électrique sur la base d'une entrée vers le dispositif d'entrée.

15. Dispositif d'entrée selon l'une quelconque des revendications 1 à 14,
dans lequel le dispositif d'entrée est au moins un dispositif d'entrée sélectionné dans une liste de dispositifs d'entrée consistant en un clavier, une manette de jeu et une souris.
